(19) Europäisches Patentamt
European Patent Office
Office européen des brevets

(11) **EP 2 000 298 A1**

(12) **EUROPEAN PATENT APPLICATION**
published in accordance with Art. 153(4) EPC

(43) Date of publication:
**10.12.2008 Bulletin 2008/50**

(51) Int Cl.:
**B32B 9/00** *(2006.01)*    **B65D 65/40** *(2006.01)*
**B65D 81/24** *(2006.01)*    **C23C 14/06** *(2006.01)*

(21) Application number: **07737586.3**

(22) Date of filing: **01.03.2007**

(86) International application number:
**PCT/JP2007/053906**

(87) International publication number:
**WO 2007/111076 (04.10.2007 Gazette 2007/40)**

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **24.03.2006 JP 2006082437**

(71) Applicant: **Konica Minolta Medical & Graphic, Inc.
Hino-shi,
Tokyo 191-8511 (JP)**

(72) Inventor: **TAKEYAMA, Toshihisa
Tokyo 191-8511 (JP)**

(74) Representative: **McCluskie, Gail Wilson
J.A. Kemp & Co.
14 South Square
Gray's Inn
London WC1R 5JJ (GB)**

(54) **TRANSPARENT BARRIER SHEET AND METHOD FOR PRODUCING TRANSPARENT BARRIER SHEET**

(57)    Disclosed is a transparent barrier sheet wherein at least one transparent inorganic thin film layer and at least one transparent organic thin film layer are arranged on a base. This transparent barrier sheet is **characterized in that** the transparent organic thin film layer is formed by cross-linking a first compound having at least three isocyanate groups on a molecule and a second compound having at least two hydroxyl groups in a molecule. This transparent barrier sheet has excellent bending resistance and high gas barrier property, and a general-purpose transparent base can be used therefor. Also disclosed is a method for producing such a transparent barrier sheet.

# FIG. 1 (a)

EP 2 000 298 A1

## FIG. 1 ( c )

1c

103
102
103
102
104
101

## FIG. 1 ( e )

1e

102
103
102
104
101

## FIG. 1 ( b )

1b

103
102
104
101

## FIG. 1 ( d )

1d

103
102
103
102
104
101
104'
102'
103'
102'
103'

**Description**

**TECHNICAL FIELD**

The present invention relates to a transparent barrier sheet for packaging employed in the packaging fields of foods and medicines, or a transparent barrier sheet employed for members related to electronic equipment and a production method of the same.

**BACKGROUND ART**

In recent years, in order to confirm contents, transparent packaging materials have been sought for packaging foods and medicines. Further, in order to minimize effects of permeated oxygen, water vapor, and other gases which adversely affect the content, gas barrier properties are demanded to maintain function and properties of packaged goods. Conventionally, when a high degree of gas barrier properties is demanded, packaging materials have been employed in which foil composed of metals such as aluminum is employed as a gas barring layer. However, the above packaging materials, which employ metal foil as a gas barrier, exhibit a high degree of gas barrier properties, which are not affected by temperature and humidly but have resulted in problems in which it is not possible to confirm contents through the packing material and it is not possible to use a metal detector during inspection.

Consequently, in recent years, in order to enhance the performance, have been developed and proposed, for example, are transparent barrier materials which are prepared in such a manner that a sputtered layer of metal oxides such as silicon oxide or aluminum oxide are provided on one side of a plastic substrate. However, in order to enhance the gas barrier properties, when the thickness of such inorganic material layer is increased beyond a certain value, cracking is induced due to insufficient flexibility and plasticity, whereby the gas barrier properties is degraded.

Further, in order to overcome the above drawbacks, it is proposed to realize excellent gas barrier properties by applying a thin organic layer of a crosslinked structure together with a thin inorganic layer onto a transparent plastic substrate (refer, for example, to Patent Documents 1).

A transparent gas barrier layer body (corresponding to the transparent barrier material of the present invention) is known (refer, for example, to Patent Document 2) which incorporates a substrate composed of a transparent plastic material having, on at least one side, a thin deposition layer composed of inorganic oxides such as aluminum oxide, silicon oxide, or magnesium oxide, further having thereon a vacuum deposition curing coating layer composed of polymerizable monomers or oligomers having a polymerizable portion such as an acrylate group, a methacrylate group, or a vinyl group, or mixtures thereof.

However, shrinkage of the layer prepared by cross-linking monomers having a radically polymerizable unsaturated double bond, described in Patent Documents 1 and 2, is more than that prior to polymerization, whereby the resultant transparent barrier sheet results in curling, and surface unevenness results due to separation of monomers from the layer. Furthermore, folding resistance is occasionally reduced to result in degradation of barrier properties due to cracking.

Transparent barrier materials are known (refer, for example, to Patent Document 3) which are provided with a polyurea layer, which is prepared by cross-linking compounds having an amino group with compounds having an isocyanate group, employing a deposition polymerization method on the thin deposition layer, which is composed of inorganic oxides such as aluminum oxide or silicon oxide on at least one side of a substrate composed of a transparent plastic material. However, the polyurea layer, described in Patent Document 3, is prepared by cross-linking, commonly at a relatively high temperature, compounds having an amino group with compounds having an isocyanate group, whereby problems occur in which it is possible to employ the resultant layer only when the substrate sheet exhibits sufficient heat resistance.

Under such a situation, sought has been development of a transparent barrier sheet which incorporates a substrate having thereon at least one thin transparent inorganic layer and at least one thin organic layer, and which exhibits excellent folding resistance, enables the use of a common transparent substrate, and results in high barrier properties against gasses, as well as its production method.

(Patent Document 1) Japanese Patent Publication Open to Public Inspection (hereinafter referred to as JP-A) No. 2003-276115
(Patent Document 2) JP-A No. 2005-178010
(Patent Document 3) JP-A No. 2003-300273

## DISCLOSURE OF THE INVENTION

### PROBLEMS TO BE SOLVED BY THE INVENTION

In view of the foregoing, the present invention was achieved. An object of the present invention is to provide a transparent barrier sheet which incorporates a substrate having thereon at least one thin transparent inorganic layer and at least one thin organic layer, and which exhibits excellent folding resistance, enables the use of a common transparent substrate, and results in high barrier properties against gasses, and a production method thereof.

### MEANS TO SOLVE THE PROBLEMS

The above object of the present invention is accomplished employing the following embodiments.

(1) A transparent barrier sheet comprising:

a substrate;
a transparent inorganic thin layer; and
a transparent organic thin layer,

wherein the transparent organic thin layer is formed by cross-linking:

a first compound having three or more isocyanate groups in the molecule; and
a second compound having two or more hydroxyl groups in the molecule.

(2) A transparent barrier sheet of the above-described item 1,
wherein a content of the isocyanate groups in the first compound is 30 to 65 weight% based on the molecular weight of the first compound.
(3) A transparent barrier sheet of the above-described items 1 or 2,
wherein a molecular weight of the second compound is from 100 to 2000.
(4) A transparent barrier sheet of any one of the above-described items 1 to 3,
wherein the transparent inorganic thin layer and the transparent organic thin layer are provided in that order on the substrate sheet.
(5) A transparent barrier sheet of any one of the above-described items 1 to 4,
wherein a primary layer is provided between the substrate sheet and the transparent inorganic thin layer.
(6) A transparent barrier sheet of any one of the above-described items 1 to 5,
wherein a second transparent inorganic thin layer is provided on the transparent organic thin layer.
(7) A transparent barrier sheet of any one of the above-described items 1 to 6,
wherein a second transparent inorganic thin layer; and a second transparent organic thin layer are provided in that order on the transparent organic thin layer.
(8) A transparent barrier sheet of any one of the above-described items 1 to 7,
wherein a thickness of the transparent organic thin layer is from 50 nm to 5.0 $\mu$m.
(9) A method of producing a transparent barrier sheet of any one of the above-described items 1 to 8, comprising the steps of in the order named:

forming the transparent inorganic thin layer on the substrate sheet; and
forming the transparent organic thin layer,

wherein a maximum attained temperature T (in K) of the substrate sheet is controlled to be in the range of 243 to 383 K during the formations of the transparent inorganic thin layer and the transparent organic thin layer.
(10) A method of producing a transparent barrier sheet of the above-described item 9,
wherein the maximum attained temperature T (in K) of the substrate sheet is controlled to satisfy Formula (1):

```
Formula (1)
```

$$1.41 \leq (T \times S)/1000 \leq 460$$

wherein S (in second) represents a required time to form the transparent inorganic thin layer and the transparent organic thin layer.

(11) A method of producing a transparent barrier sheet of the above-described items 9 or 10, wherein the transparent inorganic thin layer and the transparent organic thin layer are formed by employing a vapor deposition method.

(12) A method of producing a transparent barrier sheet of any one of the above-described items 9 to 11,

wherein the step of forming the transparent organic thin layer comprises the steps of:

depositing on the transparent inorganic thin layer vapors of:

the first compound having three isocyanate groups in the molecule; and
the second compound having two or more hydroxyl groups in the molecule,
polymerizing the deposited vapors by irradiating with actinic rays or by heating.

## EFFECTS OF THE INVENTION

It was achieved to provide a transparent barrier sheet which incorporates a substrate having thereon at least one thin transparent inorganic layer and at least one thin organic layer, and which exhibits excellent folding resistance, resulting in high barrier properties against gasses for all-purpose. And a production method thereof was achieved. It widened the using conditions of the transparent barrier sheet, and the application fields thereof was enlarged.

## BRIEF DESCRIPTION OF THE DRAWINGS

Fig. 1 is a schematic sectional view showing one example of the layer configuration of the transparent barrier sheet of the present invention.
Fig. 2 is a schematic flow diagram of a production process of the transparent barrier sheet of the present invention.

## DESCRIPTION OF SYMBOLS

1a - 1e: transparent barrier sheet
101: substrate
102, 102': thin transparent inorganic layer
103, 103': thin transparent organic layer
104, 104': transparent primer layer

## PREFERRED EMBODIMENTS TO CARRY OUT THE INVENTION

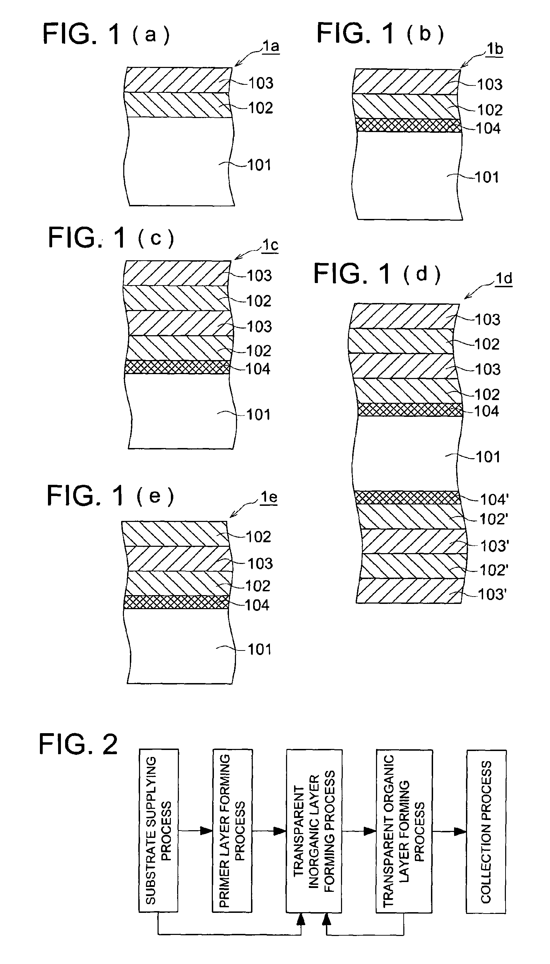

Embodiments of the present invention will now be described with reference to Figs. 1 and 2; however, the present invention is not limited thereto.

Fig. 1 is a schematic sectional view showing one example of the layer configuration of the transparent barrier sheet of the present invention.

The transparent barrier sheet shown in Fig. 1(a) will now be described. In Fig. 1(a), 1a is a transparent barrier sheet. Transparent barrier sheet 1a is constituted in such a manner that onto substrate 102, thin transparent inorganic layer 102 and thin transparent organic layer 103 are applied in that order.

The barrier sheet shown in Fig. 1(b) will be described next. In Fig. 1(b), 1b is a transparent barrier sheet. Numeral 104 is a transparent primer layer provided between substrate 101 and thin transparent inorganic layer 102. Transparent primer layer 104 may be a single layer or if desired, a plurality of layers. By providing transparent primer layer 104, it is possible to minimize defects of thin transparent inorganic layer 102 due to projections and foreign matter on substrate 101 to result in enhancement of the close contact between substrate 101 and thin transparent inorganic layer 102, and further to prepare a transparent barrier sheet exhibiting excellent folding resistance. Other numeral designations are as defined for Fig. 1(a).

The transparent barrier sheet shown in Fig. 1(c) will now be described. In Fig. 1(c), 1c is a transparent barrier sheet. Thin transparent inorganic layer 102 is constituted in such a manner that when a combination of thin transparent inorganic layer 102 and thin transparent organic layer 103 is regarded as 1 unit, onto transparent primer layer 104 provided on substrate 101, 2 units are applied. Considering gas barrier properties and folding resistance under relatively high temperature and high humidity, the number of units applied onto transparent primer layer 104 provided on substrate 101 is preferably at least 2, is more preferably in the range of 2 - 10 units, but is most preferably in the range of 2 - 5 units. By applying at least 2 units, it is possible to enhance barrier properties and folding resistance under relatively high temperature and high humidity.

The barrier sheet shown in Fig. 1(d) will now be described. In Fig. 1(d), 1d is a transparent barrier sheet. Transparent barrier sheet 1d is constituted as shown in Fig. 1(c) on both sides of substrate 101. Numeral 104' is a transparent primer layer, and 102' is a thin transparent inorganic layer, while 103' is a thin transparent organic layer. Other numeral designations are as defined for Fig. 1(a).

The transparent barrier sheet shown in Fig. 1(e) will be described next. In Fig. 1(e), 1e is a transparent barrier sheet. Transparent barrier sheet 1e carries a layer configuration in which thin transparent inorganic layer 102 is applied onto thin transparent organic layer 103 of transparent barrier sheet 1b shown in Fig. 1(b). By realizing the layer configuration shown in Fig. 1(e), it is possible to further enhance gas barrier properties. As shown in Figs. 1(a) - 1(e), by applying, a thin transparent inorganic layer and a thin transparent organic layer onto a substrate in the above order, it is possible to minimize problems such as cracking of the thin transparent inorganic layer applied to secure barrier properties even when external stress is applied.

It is not possible to indiscriminately define the transparent barrier sheet, as described in the present invention, due to confirmation of contents or the use of optical members. However, the transmittance of total radiation is commonly in the range of 50 - 95% as specified in JIS K 7105.

As shown in the present figures, the transparent barrier sheet of the present invention is constituted to incorporate a substrate having thereon at least one thin transparent inorganic layer and at least one thin transparent organic layer. When employed for packaging foods and medicines, upon considering ease of processing and handling, and practicability during formation of a transparent primer layer, a thin transparent inorganic layer, and a thin transparent organic layer, the thickness of substrate 101 is preferably in the range of 6 - 400 $\mu$m, but is most preferably in the range of 25 - 100 $\mu$m.

When the transparent barrier sheet of the present invention is applied to electronic devices such as liquid crystal elements, color type solar cells, organic or inorganic ELs, electronic paper, or fuel cells, its thickness is appropriately selected depending on each of the uses. Of these, when employed in lieu of a glass substrate, in order to comply with the post-process which is made under the glass substrate specifications, the thickness is preferably in the range of 50 - 800 $\mu$m, but is most preferably in the range of 50 - 400 $\mu$m, which is relatively thick.

The thickness of transparent primer layer 104 is preferably in the range of 0.05 - 5.0 $\mu$m, but is more preferably in the range of 0.1 - 2.0 $\mu$m.

Upon considering gas barrier properties, the thickness of thin transparent inorganic layer 102 is preferably 10 - 1,000 nm, but is more preferably 20 - 1,000 nm.

Upon considering smoothness and folding resistance, the thickness of thin transparent organic layer 103 is preferably 50 nm - 5.0 $\mu$m, but is more preferably 50 nm - 2.0 $\mu$m.

In the above case in which a plurality of units is applied as are indicated in Fig. 1(c) and Fig. 1(d), when it is necessary to consider abrasion resistance, it is preferable that the thickness of the thin transparent organic layer, which is to be the uppermost layer, is more than that of the lower thin transparent organic layer. In such a case, it is preferable to satisfy the following relationship;

$$1 < R2/R1 \leq 10$$

wherein R1 represent the maximum layer thickness of the lower transparent organic layer, while R2 represents the thickness of the uppermost thin transparent organic layer. Further, the thickness of the thin transparent organic layer, other than the uppermost thin transparent organic layer, are as follows. In order to provide excellent bending resistance, the thickness of the thin transparent inorganic layer is commonly 10 - 1,000 nm, but is preferably 20 - 500 nm. The thickness of the uppermost thin transparent organic layer is commonly 50 nm - 2.0 $\mu$m, but is preferably 50 nm - 1.0 $\mu$m by considering scratching resistance. The materials including the transparent barrier sheet shown in Fig. 1 are described below.

Substrate sheets employed in the present invention may be used without any particular limitation as long as they result in neither dimensional deformation when the following production method is employed, nor curling after coating of a thin layer. Listed as resins to form the sheet may, for example, be polyester based resins such as polyethylene terephthalate (PET), or polyethylene naphthalate; polyolefin based resins such as polyethylene or polypropylene; styrene based resins such as polystyrene or acrylonitrile-styrene copolymers; acryl based resins such as polymethyl methacrylate or methacrylic acid-maleic acid copolymers; cellulose based resins such as triacetyl cellulose; vinyl based resins such as polyvinyl chloride; imido based resins such as polyimide, fluorinate polyimide, or polyetherimide; amido based resins such as nylon 6, nylon 66, or MXD nylon 6; polycarbonate resins composed of bisphenol A, bisphenol Z, or 1-bis(4-hydroxyphenyl)-3,3,5-trimethylcyclohexane; polyacrylate resins, fluororesins; polyethersulfone resins; polysulfone resins; polyether ketone resins; or alicyclic polyolefin resins such as alicyclic polyolefin, or alicyclic olefin copolymers.

Substrate sheets include those which have been stretched or not stretched as long as the object of the present invention is not adversely affected, and preferred are those which exhibit sufficient mechanical strength and dimensional stability. Of these, biaxially stretched polyethylene terephthalate or polyethylene naphthalate is preferred for the use of thin substrate sheets. On the other hand, when substrate sheets are relatively thick, the above-cited polyester based resins such as polyethylene terephthalate or polyethylene naphthalate, polyarylate resins, polyether sulfone resins, polycarbonate resins, or alicyclic polyolefin resins are preferred in view of dimensional stability, chemical resistance, and heat resistance.

Further, if desired, various additives may be added to substrate sheets of the present invention in a range which does not adversely affect the present invention. Cited as such additives may, for example, be plasticizers, dyes and pigments, antistatic agents, UV absorbers, antioxidants, minute inorganic particles, peeling enhancing agents, leveling agents, inorganic layer-shaped silicates, and lubricants.

The substrate may be composed of any of the aforementioned single thermoplastic resins or may exhibit a multi-layer configuration which results via coating each of the quality-different thermoplastic resins. Either of the layer configurations may appropriately be selected and then employed.

If desired, the transparent primer layer according to the present invention is provided to improve smoothness and adhesion properties of the substrate sheet when the thin transparent inorganic layer is applied. The following listed resin materials may be employed to prepare the transparent primer layer.

The above-described resins include polyester based resins, urethane based resins, acryl based resins, styrene based resins, cellulose based resins, polyvinyl acetal based resins, and vinyl chloride based resins. It is possible to select and employ any appropriate one(s) from these.

Further listed as metal alkoxides are those metals with alcohol such as methyl alcohol, ethyl alcohol, or isopropyl alcohol, and listed as metals may be silicon, titanium, or zirconium.

As UV radiation curable resins or electron beam curable resins, other than compounds such as styrene based monomers or compounds having an unsaturated double bond in the molecule such as acryl based monomers, selected and employed may be any suitable one(s) from compounds having an oxetane ring, which are employed to form the thin transparent organic layer described below, and compounds having an oxirane ring, or compounds having an alkenyl ether group, an allene ether group, a ketene acetal group, a tetrahydrofuran group, an oxepane group, a single ring acetal group, a double ring acetal group, a lactone group, a cyclic orthoester group, or a cyclic carbonate group. A composition prepared by combining the above compounds with cross-linking agents is applied onto substrate sheet to form a layer followed by curing, whereby it is possible to form a transparent primer layer.

Further, heat curable resins are suitably selected from combinations with compounds or resins having an epoxy group and an amino group, combinations of acid anhydrides with compounds or resins having an amino group, or combinations of compounds or resins having hydroxyl group with compounds or resins having an isocyanate group, other than heat curing resins such as phenol resins, epoxy resins, melamine resins, urea resins, unsaturated polyester, or alkyd resins, which are widely employed, and then employed.

The thin transparent inorganic layers according to the present invention may be employed without particular limitation as long as they exhibit gas barrier properties and are transparent. Specific examples which form the thin inorganic layer include oxides incorporating at least one of Si, Al, In, Sn, Zn, Mg, Ca, K, Na, B, Ti, Pb, Zr, Y, In, Ce, and Ta, or nitrides and oxidized nitrides. Suitable ones may be selected and then employed. Further, when employed to confirm contents or applied to electronic devices, those, which have not clear maximum absorption wavelength in the visible region, are preferred.

Of these, employed as inorganic oxides may be oxides of metals such as silicon (Si), aluminum (Al), Zinc (Zn), magnesium (Mg), calcium (Ca), potassium (K), tin (Sn), sodium (Na), boron (B), titanium (Ti), lead (Pb), zirconium (Zr), Yttrium (Y), or Indium (In).

Of these, metal oxides are represented by $MO_X$ (in which M represents a metal element, and each value of X differs in the range depending on the metal element), such as $SiO_x$, $AlO_X$, or $MgO_X$. Further, with regard to the range of the X value, the possible value range is as follows; $0 < X \leq 2$ for silicon (Si), $0 < X \leq 1.5$ for aluminum (Al), $0 < X \leq 1$ for zinc (Zn), $0 < X \leq 1$ for magnesium (Mg), $0 < X \leq 1$ for calcium (Ca), $0 < X \leq 0.5$ for potassium (K), $0 < X \leq 2$ for tin (Sn), $0 < X \leq 0.5$ for sodium (Na), $0 < X \leq 1.5$ for boron (B), $0 < X \leq 2$ for titanium (Ti), $0 < X \leq 1$ for lead (Pb), $0 < X \leq 2$ for zirconium (Zr), $0 < X \leq 1.5$ for yttrium (Y), and $0 < X \leq 1$ for indium (In). In the present invention, in terms of gas barrier properties, oxides of silicon (Si) and aluminum (Al) are preferred. In such a case, it is preferable to employ silicon oxide ($SiO_X$) in the range of $1.0 \leq X \leq 2.0$ and aluminum oxide ($AlO_X$) in the range of $0.5 \leq X \leq 1.5$.

In view of transparency as an inorganic nitride, silicon nitrides are preferred. Further, as such mixtures, silicon nitride oxides are preferred. Silicon nitride oxide is represented by $SiO_xN_y$. When enhancement of close contact capability is manly intended, it is preferable that an oxygen-rich layer is formed resulting in $1 < x < 2$ and $0 < y < 1$. When enhancement of water vapor barrier properties is mainly intended, it is preferable that a nitrogen-rich layer is formed resulting in $0 < x < 0.8$ and $0.8 < y < 1.3$.

It is characterized that a thin transparent organic layer is formed by cross-linking a first compound having at least three isocyanate groups in its molecule, with a second compound having at least two hydroxyl groups in its molecule.

Listed as the above first compound may, for example, be trimer adducts such as an adduct of 3-mol hexamethylene diisocyanate or an adduct of 3-mol 2,4-tolylene diisocyanate. However, in the present invention, in order to form a thin organic layer via deposition together with compounds having at least two hydroxyls groups in their molecule, described below, upon considering leveling properties after forming the layer and ease of deposition, relatively low molecular weight compounds are preferred. Particularly preferred as such a first compound having at least three isocyanate groups in its molecule are those in which the ratio occupied by the isocyanate group is 30 - 65% by weight with respect to the compounds. Examples of such compounds may include 1,8-diisocyante-4-isocyantemethyl-octane (at an NCO content of 50.2% by weight and a molecular weight of 251.3), 2-isocyanateethyl-2,6-diisocyanate caproate (at an NCO content of 49.8% by weight and a molecular weight of 253.2), benzene-1,3,5-triisocyanate (at an NCO content of 62.7% by weight and a molecular weight of 201.1.), 1-methylbenzene-2,4,6-triisocyanate (at an NCO content of 58.6% by weight and a molecular weight of 215.2), 1,3,5-trimethylbenzene-2,4,6-triisocyante (at an NCO content of 51.8% by weight and a molecular weight of 243.2), diphenylmethane-2,4,4'-triisocyanate (at an NCO content of 43.3% by weight and a molecular weight of 291.3), triphenylmethane-4,4',4"-triisocyanate (at an NCO content of 34.3% by weight and a molecular weight of 367.4), and bis(isocyanatotolyl)phenylmethane (at an NCO content of 42.6% by weight and a molecular weight of 291.3). These above compounds having at least three isocyanate groups in the molecule may be employed individually or in combinations of at least two types.

Further, compounds having at least two hydroxyl groups in their molecule may be employed without particular limitation. In order to assure targeted folding properties of the thin layer after cross-linking, more preferred are compounds having at least two alcoholic hydroxyl groups in their molecule. Examples of such compounds include diethylene glycol, triethylene glycol, polyethylene glycol, dipropylene glycol, tripropylene glycol, polypropylene glycol, 2,2-dimethyl-1,3-propanediol, 2,2-diethyl-1,3-propanediol, 2-buthyl-2-ethyl-1,3-propanediol, 1,2-butanediol, 1,4-butanediol, polytetramethylene glycol, 1,5-pentanediol, 2-methyl-2,4-pentanediol, 3-methyl-1,5-pentanediol, 1,6-hexanediol, 2-ethyl-1,3-hexanediol, 2,5-dimethyl-2,5-hexanediol, 1,10-decanediol, 1,4-cyclohexanediol, glycerin, 1,2,6-hexanetriol, trimethylolethane, trimethylolpropane, pentaerythritol, and sorbitol. Further included are alcohols which are prepared by modifying the cited compounds, having at least two hydroxyl groups in their molecule with dihydric alcohol such as ethylene glycol, diethylene glycol, triethylene glycol, polyethylene glycol, propylene glycol, dipropylene glycol, tripropylene glycol, polypropylene glycol, or polytetramethylene glycol. Incidentally, these compounds having at least two hydroxyl groups in their molecule may be employed individually or in combinations of at least two types. Further, upon considering leveling properties after formation of the deposition layer and ease of deposition, it is preferable to regulate the molecular weight within 100 - 2,000. Still further, to enhance barrier properties of the thin transparent organic layer of the present invention, it is preferable that the compounds having at least three hydroxyl groups in their molecule are capable of more easily undergoing three-dimensional cross-linking. Further, when it is intended to crosslink the first compound with the second compound at a relatively low temperature or to do so easily, it is preferable that tin or lead metal organic compounds known in the art are subjected to simultaneous deposition.

Further, in the transparent barrier sheet of the present invention, other than the above-mentioned essential layers, if desirable, coated may be functional layers such as an antistatic layer, an adhesion layer, an electrically conductive layer, an antireflection layer, an ultraviolet radiation protective layer. Coated location may be suitably selected in response to the use. Fig. 2 shows a schematic flow to produce a transparent barrier sheet of the present invention.

Processes to produce the transparent barrier sheet of the present invention include a substrate supplying process, a primer layer forming process, a drying process, a transparent inorganic layer forming process, a transparent organic layer forming process, and a collection process. When no primer layer is formed, during production of the transparent barrier sheet of the layer configuration, for example, shown in Fig. 1(a), the process may proceed from the substrate supplying process to the transparent inorganic layer forming process.

In the substrate supplying process, supplied is a substrate prepared by employing the above-cited thermoplastic resin materials.

In the step of producing a transparent primer layer, the transparent primer layer composition is prepared by blending the above-mentioned transparent primer layer forming components or if desirable, dissolving them in solvents or dispersing them, and then applying on a substrate.

When a dispersion is required to form a liquid coating composition, it is possible to select any of the suitable homogenizers known in the art, such as a two-roller mill, a three-roller mill, a ball mill, a pebble mill, a COBOL mill, a tron mill, a sand mill, a sand grinder, a SQEVARI attritor, a high speed impeller homogenizer, a high speed stone mill, a high speed impact mill, DISPER, a high speed mixer, a homogenizer, an ultrasonic homogenizer, an open kneader, or a continuous kneader, and then employed.

Further listed as solvents to employ for dissolution, when required: are water; ketones such as methyl ethyl ketone, methyl isobutyl ketone, or cyclohexanone; alcohols such as ethyl alcohol, n-propyl alcohol, or isopropyl alcohol; aliphatic hydrocarbons such as heptane or cyclohexane; aromatics such as toluene or xylene; glycols such as ethylene glycol or diethylene glycol; ether alcohols such as ethylene glycol monomethyl ether; ethers such as tetrahydrofuran, 1,3-dioxysolan or 1,4-dioxane; and halogen compounds such as dichloromethane or chloroform.

It is possible to apply the transparent primer layer forming composition, prepared as above, onto a substrate sheet, employing, for example, a roller coating method, a gravure roller coating method, a direct gravure roller coating method, an air doctor coating method, a rod coating method, a kiss roller coating method, a squeezing roller coating method, a reverse roller coating method, a curtain flow coating method, a fountain method, a transfer coating method, a spray coating method, a dip coating method, or other appropriate methods. Subsequently, the resulting coating is heat-dried, followed by an aging treatment, whereby it is possible to apply a transparent primer layer onto a substrate sheet. If required, it may be possible to carry out the cross-linking reaction after drying. Further, it may be overcoat a metal alkoxide, a UV cure resin, an electron beam curing resin, a thermal curing resin or a diluted composition thereof on the above-mentioned coating layer, and then it is dried to cure.

Further, in the present invention, when the transparent primer layer forming composition is applied onto a substrate sheet, it is preferable that after performing a suitable surface treatment selected from a flame treatment, an ozone treatment, a glow discharge treatment, a corona discharge treatment, a plasma treatment, a vacuum ultraviolet radiation exposure treatment, an electron beam exposure treatment, or a radiation exposure treatment, the transparent primer layer forming composition is applied onto a substrate sheet. By treating the surface of the substrate sheet as described above, it is possible to enhance adhesion between the substrate sheet and the transparent primer layer.

When the employed transparent primer layer forming components are the same as the thin transparent organic layer forming compositions, the same method as used to coat the thin transparent organic layer, to be described below, may be employed.

In the step of forming a transparent inorganic thin layer, a transparent primer layer formed on a substrate is further overcoated with a transparent inorganic thin layer by employing the above-described materials. The methods to form the transparent inorganic thin layer are not specifically limited.

Listed as forming methods of the thin transparent inorganic layer may, for example, be a vacuum deposition method, a sputtering method, an ion plating method, a reactive plasma deposition method, an method employing an electron cyclotron resonance plasma, a plasma chemical vapor deposition method, a thermochemical vapor deposition method, a photochemical vapor deposition method, a catalytic chemical vapor deposition method, and a vacuum ultraviolet radiation chemical vapor deposition method. Of these methods, it is preferable that the thin transparent inorganic layer is formed employing at least one of the catalytic chemical vapor deposition method (namely a Cat-CPD method), the reactive plasma deposition method (namely an RPD method), and the electron cyclotron resonance (ECR) plasma deposition method, which result in a layer exhibiting a relatively flat and smooth surface due to relatively little surface roughness on the formed thin transparent inorganic layer.

A specific method and deposition device of the above catalytic chemical vapor deposition method may suitably be selected from those described, for example, in JP-A Nos. 2002-69644, 2002-69646, 2002-299259, 2004-211160, 2004-217966, 2004-292877, 2004-315899, and 2005-179693, and may then be employed upon improvement of the shape suitable for the purpose of the present invention.

Further, a specific method and deposition device of the reactive plasma vapor deposition method may suitably be selected from those described, for example, in JP-A Nos. 2001-262323, 2001-295031, 2001-348660, 2001-348662, 2002-30426, 2002-53950, 2002-60929, 2002-115049, 2002-180240, 2002-217131, 2002-249871, 2003-105526, 2004-76025, and 2005-34831, and may then be employed upon improvement of the shape suitable for the purpose of the present invention.

Still further, a specific method and deposition device of the ECR plasma deposition method may suitably be selected from those described, for example, on pages 152 - 154 and 226 in Tatsuo Asagi, "Hakumaku Sakusei no Kiso (Basis of Thin Layer Formation)" (published by Nikkan Kogyo Shinbun Sha, March 1996), and in JP-A Nos. 3-197682, 4-216628, 4-257224, 4-311036, 5-70955, 5-90247, 5-9742, 5-117867, 5-129281, 5-171435, 6-244175, 6-280000, 7-263359, 7-335575, 8-78333, 9-17598, 2003-129236, 2003-303698, and 2005-307222, and may then be employed upon improvement of the shape suitable for the purpose of the present invention.

In the thin transparent organic layer forming process, a thin transparent organic layer is applied onto a thin transparent inorganic layer which has been applied onto the transparent primer layer during the thin transparent inorganic layer forming process.

An example as the deposition method of the thin transparent organic layer formed on the above-mentioned thin transparent inorganic layer may be a coating when the above primer layer is formed, or a deposition method. However, in the transparent barrier sheet of the present invention, it is preferable to employ the deposition method so that the thin transparent inorganic layer, functioning as a barrier layer, is not damaged.

More specifically, it is possible to form a thin transparent organic layer in such a manner that after applying, onto the thin transparent inorganic layer, compounds having at least three isocyanate groups in their molecule (being the first compounds) and compounds having at least two hydroxyl groups in their molecule (being the second compounds), employing a deposition method, a cross-linking reaction is performed via heating. The heating temperature varies depending on the types of the first compounds and the second compounds, whereby it is preferable that heating is carried out appropriately after determining optimal temperature.

When the first compounds and the second compounds are subjected to deposition, deposition conditions may be set individually. When no cross-linking reaction results and no problems occur at slight differences in the deposition rate of the above compounds, those deposition conditions may be set for the mixture as a composition.

A specific method and layer forming device of the above-mentioned deposition method may suitably be selected from those described, for example, in JP-A Nos. 2-284485, 5-125520, 5-177163, 5-311399, 5-339389, 6-116409, 6-316757, 7-26023, 7-209863, 9-143681, 9-249851, 9-272703, 9-278805, 9-279332, 9-326389, 10-92800, 10-168559, 10-289902, 11-172418, 2000-87224, 2000-127186, 2000-348971, 2001-261867, 2002-275619, 2003-3250, 2003-300273, 2003-335880, and 2005-14483, as well as in Japanese Patent Publication Open to Public Inspection (under PCT Application) Nos. 8-503099, and they may then be employed upon improvement of the shape suitable for the purpose of the present invention.

During formation of the transparent barrier sheet of the present invention, in order to minimize thermal deformation of the substrate, it is preferable to satisfy the conditions of following Formula (1) so that a transparent barrier sheet with fewer defects can be prepared. Further, it is also preferable to satisfy the conditions of following Formula (2) so that the transparent barrier sheet of further fewer defects can be prepared. Wherein T (in K) represents a maximum attained temperature and S (in seconds) represents a layer forming time. As used herein, "maximum attained temperature T (in K) and layer forming time S (in seconds)" of the substrate during formation of the thin transparent organic layer and the thin transparent inorganic layer relates to a process to form a single layer. When the thin transparent organic layer and the thin transparent inorganic layer are employed to form a plurality of layers, the above values represent layer forming conditions to form a single layer. Further, the layer forming time, as described herein, represents layer forming time at a certain point of the substrate.

$$\text{Formula (1)} \quad 1.41 \leq (T \times S)/1000 \leq 460$$

$$\text{Formula (2)} \quad 1.45 \leq (T \times S)/1000 \leq 350$$

Further, to minimize thermal deformation of substrate sheets during preparation of the transparent barrier sheet of the present invention, it is preferable to regulate the maximum attained temperature T, in K of the substrate sheet to the range of 283 - 383 K, but is more preferably to regulate it to the range of 293 - 333 K. Further, it is more preferable that maximum attained temperatures T (in K) of the substrate sheet is within the range represented by following Formula (3):

$$\text{Formula (3)} \quad 0.54 \leq T/Tg \leq 0.98$$

In the collection process, the transparent barrier sheet (Fig. 1(b)), incorporating a substrate coated thereon with the primer sheet, the thin transparent inorganic layer, and the thin transparent organic layer in that order, is collected. Further, it is possible to produce the transparent barrier sheet, shown in Fig. 1(a), in such a manner that except for no use of the primer layer forming process, production is carried out under the same conditions as the transparent barrier sheet shown in Fig. 1(b). It is possible to produce the transparent barrier sheet shown in Fig. 1(e) in such a manner that after forming the thin transparent organic layer, a thin transparent inorganic layer is again formed on the thin transparent organic layer during formation of the thin transparent inorganic layer. It is possible to produce the transparent barrier sheet shown in Fig. 1(c) in such a manner that after completing the thin transparent organic layer forming process shown in the above figure, in the thin transparent inorganic layer forming process, a thin transparent inorganic layer and a thin transparent organic layer are again successively applied. It is possible to produce the transparent barrier sheet shown in Fig. 1(d) in such a manner that after achieving the layer configuration of the transparent barrier sheet shown in Fig. 1(c), a transparent primer layer, a thin transparent inorganic layer, and a thin transparent organic layer are successively applied. Further, the substrate employed in the production flow, as shown in the above figure, may include sheets of film and long bands of film wound in a roll. Further, it is preferable that the transparent primer layer, the thin transparent inorganic layer and the thin transparent organic layer are each subjected to batch processing. However, when the thin transparent inorganic layer forming conditions match the thin transparent organic layer forming conditions, it is possible to continuously apply a thin transparent inorganic layer and a thin transparent organic layer onto a long band of film wound into a roll. On the other hand, in the transparent barrier sheet of the present invention, other than the essential layers, it is possible to also coat functional layers such as an antistatic layer, an adhesive layer, an electrically conductive lawyer, an antireflection layer, a UV radiation minimizing layer, or a near-infrared minimizing layer, which are provided when desired, employing any suitable method which is selected from the coating methods for thin transparent inorganic layer or thin transparent organic layers.

**EXAMPLES**

The barrier sheet of the present invention will now be described with reference to specific examples, however the present invention is not limited thereto. "Parts" represent parts by weight unless otherwise specified.

Example 1 (Preparation of Substrate)

A 100 $\mu$m thick polyether sulfone film (SUMILITE FS-5300, produced by Sumitomo Bakelite Co., Ltd.) was prepared as a substrate sheet. Its glass transition point Tg was 496 K.

(Coating of Thin Transparent Inorganic Layer)

Cooling plate 10 was placed on the rear surface of the prepared substrate sheet and a thin transparent inorganic layer composed of silicon nitride oxide was formed employing a reaction type plasma deposition apparatus (downsized plasma layer forming apparatus of to 370 x 480 mm, produced by Sumitomo Heavy Industries Co., Ltd.), while employing silicon as a solid target. The layer was formed under conditions of a discharge current of 120 A and a layer forming pressure of 0.1 Pa, employing a gas mixture of argon : oxygen : nitrogen = 1 : 1.85 : 3.15 as the deposition atmosphere. Table 1 shows film forming time S, layer thickness, maximum attained temperature of the substrate T and (T x S)/100 of each thin transparent inorganic layer. The composition ratio of the resultant thin transparent inorganic layer, composed of silicon nitride oxide, was determined employing XPS (X-ray photoelectron spectroscopy), resulting in Si : O : N = 1.00 : 0.96 : 0.69. Further, the maximum attained temperature of the substrate during layer formation was determined as follows. A thermo-label was adhered onto the substrate surface and after layer formation, the resultant temperature was confirmed and designated as maximum attained temperature T (in K). The layer thickness of the thin transparent inorganic layer was determined employing a spectral ellipsometer FE-5000, produced by Otsuka Electronics Co., Ltd.), and the resultant values were listed.

(Coating of Thin Transparent Organic Layer)

Cooling plate 10 was placed on the rear surface of the substrate onto which a thin transparent inorganic layer had been coated. In such a state, it was placed in a vacuum tank, and the interior pressure was reduced to the order of $10^{-4}$ Pa. A first compound having an isocyanate group and a second compound having a hydroxyl group, both shown blow, were each placed in an individual vessel, and each vessel was heated to 40 °C via resistor heating. When impurities were completely evaporated, the temperature was elevated to each of the values listed in Table 1. Thereafter, the deposition shutter was opened and a thin transparent organic layer was formed on the thin transparent inorganic layer via deposition polymerization while changing the film forming time, whereby a transparent barrier sheet was prepared. The resultant sheets were designated as Sample Nos. 1-A - 1-F. The maximum attained temperature during formation of the thin transparent organic layer was determined as follows. A thermo-label was adhered onto the surface of the formed layer and after forming the thin layer, temperature T (in K) was confirmed. The thickness of the thin transparent organic layer was represented by the values determined employing a spectral ellipsometer (FE-5000, produced by Otsuka Electronics Co., Ltd.). Radiation transmittance based on JIS K 7105 of prepared Sample Nos. 1-A - 1-F was within 83 - 88% (determined by HAZE COMPUTER HGM-2B, produced by Suga Test Instruments Co. Ltd.).
A comparative transparent barrier sheet was prepared in the following manner, employing the same substrate as in Sample No. 1-A, and designated as No. 1-R.

Preparation of Comparative Sample No. 1-R

A layer forming apparatus in which a high pressure UV mercury lamp was installed in the interior of a vacuum deposition apparatus, equipped with a resistor heating terminal and an electron gun, was employed. Silicon oxide was employed to form an inorganic layer, while employed as an organic layer was a resin mixture to be cured, composed of 100 parts by weight of bifunctional dicyclopentadienyl diacrylate *1, and 1 part by weight of a photopolymerization initiator (IRUGACURE 907, produced by Ciba Specialty Chemicals, Inc.). A substrate was placed in a vacuum tank and the pressure was reduced to the order of $10^{-4}$ Pa. Thereafter, 60 nm Thin Transparent Inorganic Layer D, composed of silicon oxide, was formed employing an electron beam deposition method, employing silicon oxide as a target. Subsequently, in a state in which the degree of vacuum in the vacuum tank was stabilized to the order of $10^{-4}$ Pa, resistor heating for the organic deposition source was initiated. When impurities were completely evaporated, the deposition shutter was opened, whereby a thin transparent organic layer of 1,000 nm was subjected to deposition. After closing the deposition shutter, the UV lamp shutter was opened, and monomers were cured at an integral light anoint of 500 $mJ/cm^2$, to form Thin Transparent Organic Layer E, whereby a comparative transparent barrier sheet was produced.

First compound having an isocyanate group

N-1: 2-iocyanateethyl-2,6-diisocyanate caproate
N-2: 1,8-diisocyanate-4-isocyanatemethyl-octane

Second compound having a hydroxyl group

O-1: tripropylene glycol
O-2: 1,6-hexanediol
O-3: 2,5-dimethyl-2,5-hexanediol

Evaluation

Resulting Sample Nos. 1-A - 1-R were evaluated for oxygen permeability and water vapor permeability as well as folding resistance employing the methods described below. Table 1 shows the results.

Evaluation Method of Oxygen Permeability

A zero point was determined at 25 °C and 0% relative humidity, employing an oxygen permeability meter (OXTRAN 2/21, produced by MOCON Co.) and determined values thereafter were used. The oxygen permeability was shown in $ml/m^2 \cdot 24$ hour$\cdot 25$ °C.

Evaluation Method of Water Vapor Permeability

Values were employed, which were determined by employing a water vapor permeability meter (PERMATRAN-W 3/32, produced by MOCON Co.). The water vapor permeability was shown in $g/m^2 \cdot 24$ hours$\cdot 25$ °C.

Evaluation Method of Folding Resistance

Under the condition in which the surface of the thin transparent inorganic layer was directed toward the outside, folding was repeated 10 times along a 20 mm$\phi$ stainless steel rod at an angle of 180°. Thereafter, water vapor permeability ($g/m^2 \cdot 24$ hours$\cdot 25$ °C) was determined in the same manner as in the evaluation method of the water vapor permeability, and was designated as folding resistance.

Table 1

| | | | Inv. | Inv. | Inv. | Inv. | Inv. | Inv. | Comp. |
|---|---|---|---|---|---|---|---|---|---|
| Transparent Barrier Sheet No. | | | 1-A | 1-B | 1-C | 1-D | 1-E | 1-F | 1-R |
| | *2 | Tg[K] | 496 | 496 | 496 | 496 | 496 | 496 | 496 |
| Thin Trans-Parent Inorganic Layer | Layer Thickness | [nm] | 60 | 60 | 60 | 60 | 60 | 100 | 60 |
| | *3 | T[K] | 288 | 288 | 288 | 288 | 288 | 288 | 333 |
| | Layer Forming Time | S [econd)] | 25 | 25 | 25 | 25 | 25 | 35 | 60 |
| | | T x S/1000 [K·second] | 7.20 | 7.20 | 7.20 | 7.20 | 7.20 | 10.08 | 20.0 |
| Thin Trans-Parent Organic Layer | *4 | Type | N-1/O-1 | N-1/O-2 | N-1/O-3 | N-2/O-2 | N-2/O-3 | N-2/O-3 | *1 |
| | Vessel Temperature | [°C] | 120/200 | 120/190 | 120/150 | 110/190 | 110/150 | 110/150 | 150 |
| | Layer Thickness | [nm] | 300 | 300 | 300 | 300 | 300 | 300 | 1000 |
| | *3 | T[K] | 298 | 298 | 298 | 298 | 298 | 298 | 318 |
| | Layer Forming Time | S (second) | 380 | 370 | 360 | 380 | 350 | 360 | 750 |
| | | T x S/1000 [K·second] | 113 | 110 | 107 | 113 | 104 | 107 | 239 |
| Evaluation of Gas Barrier Properties | Water Vapor Permeability | [g/m$^2$·24hr ·25°C·90%] | <0.01 | <0.01 | <0.01 | <0.01 | <0.01 | <0.01 | 0.05 |
| | Oxygen Permeability | [ml/m$^2$·24hr ·25°C·0%] | 0.03 | <0.01 | <0.01 | <0.01 | <0.01 | <0.01 | 0.08 |
| Evaluation of Folding Resistance | Water Vapor Permeability | [g/m$^2$·24hr ·25°C·90%] | 0.04 | 0.03 | 0.02 | 0.02 | 0.02 | 0.02 | 0.12 |
| *1: Dicyclopentadienyl Diacrylate<br>*2: Glass Transition Temperature Tg of Substrate Sheet Component<br>*3: Maximum Attained Temperature, *4: Thin Organic Layer Composition Type | | | | | | | | | |

Effectiveness of the present invention was confirmed. Example 2

As a substrate sheet coated on both sides with a 100 μm thick transparent primer layer, a biaxially stretched polyethylene terephthalate film (COSMOSHINE A-4300, produced by TOYOBO Co., Ltd.) was prepared. Transparent barrier sheets were then prepared in such a manner that Thin Transparent Inorganic Layer A and Thin Transparent Organic Layer B, each of which is shown in following 1) and 2) were applied onto the above substrate sheet coated with the primer layer to realize the layer configuration listed in Table 2, whereby Sample Nos. 2-A - 2-D were prepared. In Table 2, C represents the substrate sheet coated with the transparent primer layer.

1) Formation of Thin Transparent Inorganic Layer A

In the state in which a 10 °C cooling plate was placed on the reverse side of Substrate C, coated with the transparent primer layer as above, Thin Transparent Inorganic Layer A, composed of silicon nitride, was formed employing an ECR plasma layer forming apparatus (AFTECH ER-1200, produced by NTT AFTY Corp.), while using silicon as a solid target under layer forming conditions at a microwave power of 500 W, an RF power of 500 W, and a layer forming pressure of 0.09 Pa, as well as under gas introduction conditions at an argon flow rate of 40 sccm and a nitrogen gas flow rate of 0.5 sccm. Table 2 shows the thickness of the resulting thin transparent inorganic layer, the layer forming time, and maximum attained temperature T (in K) of the substrate sheet during formation of the layer. Maximum attained temperature T (in K) of the substrate sheet was evaluated in the same manner as in Example 1.

2) Formation of Thin Transparent Organic Layer

The resultant substrate, coated with the thin transparent inorganic layer, was placed into a vacuum tank in such a manner that a 10 °C cooling plate was placed on the reverse side, and the pressure in the vacuum tank was reduced to the order of $10^{-4}$ Pa. Thereafter, a compound having an isocyanate group and a compound having a hydroxyl group were each placed in a separate vessel. Subsequently, each vessel was subjected to resistor heating to 40 °C. When the impurities were completely evaporated, each vessel was heated to the temperature listed in Table 2. Thereafter, the deposition shutter was opened, whereby a thin transparent organic layer, which was prepared via deposition polymerization on the thin transparent inorganic layer, was formed. Table 1 shows the thickness of the resulting thin transparent organic layer, the layer forming time, and maximum attained temperature T (in K) of the substrate sheet. Preparation of Comparative Sample No. 2-R

Transparent Barrier Sheet No. 2-R as a comparative sample was prepared as follows. The same substrate as Sample No. 2-A was employed. Subsequently, preparation was carried out up to Thin Transparent Organic Layer E which was the same as Comparative Sample No. 1-R of Example 1. Further, employing the same method as for Comparative Example 1, onto above Thin Transparent Organic Layer E, 60 nm Thin Transparent Inorganic Layer D composed of silicon oxide and 1,000 nm thick Thin Transparent Organic Layer E were applied, employing the electron beam deposition method and the organic deposition method, respectively, so that the layer configuration described in Table 2 was realized. Transparent Barrier Sheet No. 2-R, prepared via the above method, was evaluated for barrier properties and folding resistance, employing the same evaluation methods as for Example 1. Table 2 shows the results.

Evaluation

Table 2 shows evaluation results of resulting Sample Nos. 2-A - 2-R for oxygen permeability and water vapor permeability, as gas barrier properties, as well as folding resistance, which were evaluated employing the same methods as for Example 1. In Table 2, oxygen permeability is in ml/m$^2$·24 hr·25 °C, while water vapor permeability is in g/m$^2$·24 hr·25 °C.

**EP 2 000 298 A1**

Table 2

| | | | Inv. | Inv. | Inv. | Inv. | Comp. |
|---|---|---|---|---|---|---|---|
| Transparent Barrier Sheet No. | | | 2-A | 2-B | 2-C | 2-D | 2-R |
| *2 | | Tg[K] | 340 | 340 | 340 | 340 | 340 |
| Thin Transparent Inorganic Layer | Layer Thickness | [nm] | 60 | 60 | 60 | 100 | 60 |
| | *3 | T[K] | 293 | 293 | 293 | 293 | 333 |
| | Layer Forming Time | S [second] | 720 | 720 | 720 | 750 | 60 |
| | | T x S/1000 [K ·second] | 211 | 211 | 211 | 220 | 20 |
| Thin Transparent Organic Layer | *4 | Type | N-2/O-2 | N-2/O-2 | N-2/O-2 | N-1/O-2 | *1 |
| | Vessel Temperature | [°C] | 110/190 | 110/190 | 110/190 | 120/190 | 150 |
| | Layer Thickness | [nm] | 300 | 300 | 300 | 300 | 1000 |
| | *3 | T[K] | 298 | 298 | 298 | 298 | 318 |
| | Layer Forming Time | S [second] | 380 | 380 | 380 | 370 | 750 |
| | | T x S/1000 [K ·second] | 113 | 113 | 113 | 110 | 239 |
| Layer Configuration | | | C/A/B | C/A/B/A | C/A/B/A/B | C/A/B | C/D/E/D/E |
| Evaluation of Gas Barrier Properties | Water Vapor Permeability | [g/m$^2$·24hr ·25 °C·90%] | <0.01 | <0.01 | <0.01 | <0.01 | 0.03 |
| | Oxygen Permeability | [ml/m$^2$·24hr ·25 °C·0%] | <0.01 | <0.01 | <0.01 | <0.01 | 0.05 |
| Evaluation of Folding Resistance | Water Vapor Permeability | [g/m$^2$·24hr ·25 °C·90%] | 0.02 | <0.01 | <0.01 | <0.01 | 0.08 |
| Inv.: Present Invention, Comp.: Comparative Example, *1: Dicyclopentadienyl Diacrylate, *2: Glass Transition Temperature Tg of Substrate Sheet Component *3: Maximum Attained Temperature, *4: Thin Organic Layer Composition Type Effectiveness of the present invention was confirmed. | | | | | | | |

**Claims**

1. A transparent barrier sheet comprising:

   a substrate;
   a transparent inorganic thin layer; and
   a transparent organic thin layer,

   wherein the transparent organic thin layer is formed by cross-linking:

   a first compound having three or more isocyanate groups in the molecule; and
   a second compound having two or more hydroxyl groups in the molecule.

2. The transparent barrier sheet of claim 1,
   wherein a content of the isocyanate groups in the first compound is 30 to 65 weight% based on the molecular weight of the first compound.

3. The transparent barrier sheet of claims 1 or 2,
wherein a molecular weight of the second compound is from 100 to 2000.

4. The transparent barrier sheet of any one of claims 1 to 3,
wherein the transparent inorganic thin layer and the transparent organic thin layer are provided in that order on the substrate sheet.

5. The transparent barrier sheet of any one of claims 1 to 4,
wherein a primary layer is provided between the substrate sheet and the transparent inorganic thin layer.

6. The transparent barrier sheet of any one of claims 1 to 5,
wherein a second transparent inorganic thin layer is provided on the transparent organic thin layer.

7. The transparent barrier sheet of any one of claims 1 to 6,
wherein a second transparent inorganic thin layer; and a second transparent organic thin layer are provided in that order on the transparent organic thin layer.

8. The transparent barrier sheet of any one of claims 1 to 7,
wherein a thickness of the transparent organic thin layer is from 50 nm to 5.0 $\mu$m.

9. A method of producing a transparent barrier sheet of any one of claims 1 to 8, comprising the steps of in the order named:

forming the transparent inorganic thin layer on the substrate sheet; and
forming the transparent organic thin layer,

wherein a maximum attained temperature T (in K) of the substrate sheet is controlled to be in the range of 243 to 383 K during the formations of the transparent inorganic thin layer and the transparent organic thin layer.

10. The method of producing a transparent barrier sheet of claim 9,
wherein the maximum attained temperature T (in K) of the substrate sheet is controlled to satisfy Formula (1):

$$\text{Formula (1)}$$

$$1.41 \leq (T \times S)/1000 \leq 460$$

wherein S (in second) represents a required time to form the transparent inorganic thin layer and the transparent organic thin layer.

11. The method of producing a transparent barrier sheet of claims 9 or 10,
wherein the transparent inorganic thin layer and the transparent organic thin layer are formed by employing a vapor deposition method.

12. The method of producing a transparent barrier sheet of any one of claims 9 to 11,
wherein the step of forming the transparent organic thin layer comprises the steps of:

depositing on the transparent inorganic thin layer vapors of:

the first compound having three isocyanate groups in the molecule; and
the second compound having two or more hydroxyl groups in the molecule,

polymerizing the deposited vapors by irradiating with actinic rays or by heating.

FIG. 1 ( a )

FIG. 1 ( b )

FIG. 1 ( c )

FIG. 1 ( d )

FIG. 1 ( e )

FIG. 2

<table>
<tr><td align="center"><b>INTERNATIONAL SEARCH REPORT</b></td><td>International application No.<br>PCT/JP2007/053906</td></tr>
</table>

| A. CLASSIFICATION OF SUBJECT MATTER |
|---|
| *B32B9/00*(2006.01)i, *B65D65/40*(2006.01)i, *B65D81/24*(2006.01)i, *C23C14/06* (2006.01)i |
| According to International Patent Classification (IPC) or to both national classification and IPC |

| B. FIELDS SEARCHED |
|---|
| Minimum documentation searched (classification system followed by classification symbols)<br>B32B1/00-43/00, B65D65/40, B65D81/24, C23C14/06 |
| Documentation searched other than minimum documentation to the extent that such documents are included in the fields searched<br> Jitsuyo Shinan Koho 1922-1996 Jitsuyo Shinan Toroku Koho 1996-2007<br> Kokai Jitsuyo Shinan Koho 1971-2007 Toroku Jitsuyo Shinan Koho 1994-2007 |
| Electronic data base consulted during the international search (name of data base and, where practicable, search terms used) |

| C. DOCUMENTS CONSIDERED TO BE RELEVANT | | |
|---|---|---|
| Category* | Citation of document, with indication, where appropriate, of the relevant passages | Relevant to claim No. |
| Y | JP 2005-35204 A (Onoike Kogyo Kabushiki Kaisha),<br>10 February, 2005 (10.02.05),<br>Claims; Par. Nos. [0029], [0044], [0045]<br>(Family: none) | 1-12 |
| Y | JP 2002-178435 A (Tohcello Co., Ltd.),<br>26 June, 2002 (26.06.02),<br>Par. Nos. [0012], [0015] to [0023]<br>(Family: none) | 1-12 |
| Y | JP 2004-160836 A (Mitsui Chemicals, Inc.),<br>10 June, 2004 (10.06.04),<br>Par. No. [0060]<br>(Family: none) | 9-12 |

| ☒ Further documents are listed in the continuation of Box C. | ☐ See patent family annex. |
|---|---|

| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |
|---|---|

| Date of the actual completion of the international search<br> 14 May, 2007 (14.05.07) | Date of mailing of the international search report<br> 22 May, 2007 (22.05.07) |
|---|---|
| Name and mailing address of the ISA/<br> Japanese Patent Office | Authorized officer |
| Facsimile No. | Telephone No. |

Form PCT/ISA/210 (second sheet) (April 2005)

| | INTERNATIONAL SEARCH REPORT | International application No. |
|---|---|---|
| | | PCT/JP2007/053906 |

C (Continuation). DOCUMENTS CONSIDERED TO BE RELEVANT

| Category* | Citation of document, with indication, where appropriate, of the relevant passages | Relevant to claim No. |
|---|---|---|
| Y | JP 2003-191370 A  (Sumitomo Bakelite Co., Ltd.),<br>08 July, 2003 (08.07.03),<br>Par. No. [0006]<br>(Family: none) | 11,12 |
| Y | JP 2005-246716 A  (Fuji Photo Film Co., Ltd.),<br>15 September, 2005 (15.09.05),<br>Par. Nos. [0058], [0059]<br>(Family: none) | 11,12 |

Form PCT/ISA/210 (continuation of second sheet) (April 2005)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2003276115 A
- JP 2005178010 A
- JP 2003300273 A
- JP 2002069644 A
- JP 2002069646 A
- JP 2002299259 A
- JP 2004211160 A
- JP 2004217966 A
- JP 2004292877 A
- JP 2004315899 A
- JP 2005179693 A
- JP 2001262323 A
- JP 2001295031 A
- JP 2001348660 A
- JP 2001348662 A
- JP 2002030426 A
- JP 2002053950 A
- JP 2002060929 A
- JP 2002115049 A
- JP 2002180240 A
- JP 2002217131 A
- JP 2002249871 A
- JP 2003105526 A
- JP 2004076025 A
- JP 2005034831 A
- JP 3197682 A
- JP 4216628 A
- JP 4257224 A
- JP 4311036 A
- JP 5070955 A
- JP 5090247 A
- JP 5009742 A
- JP 5117867 A
- JP 5129281 A
- JP 5171435 A
- JP 6244175 A
- JP 6280000 A
- JP 7263359 A
- JP 7335575 A
- JP 8078333 A
- JP 9017598 A
- JP 2003129236 A
- JP 2003303698 A
- JP 2005307222 A
- JP 2284485 A
- JP 5125520 A
- JP 5177163 A
- JP 5311399 A
- JP 5339389 A
- JP 6116409 A
- JP 6316757 A
- JP 7026023 A
- JP 7209863 A
- JP 9143681 A
- JP 9249851 A
- JP 9272703 A
- JP 9278805 A
- JP 9279332 A
- JP 9326389 A
- JP 10092800 A
- JP 10168559 A
- JP 10289902 A
- JP 11172418 A
- JP 2000087224 A
- JP 2000127186 A
- JP 2000348971 A
- JP 2001261867 A
- JP 2002275619 A
- JP 2003003250 A
- JP 2003335880 A
- JP 2005014483 A
- JP 8503099 PCT

**Non-patent literature cited in the description**

- **TATSUO ASAGI.** Hakumaku Sakusei no Kiso. Nikkan Kogyo Shinbun Sha, March 1996, 152-154